# EUROPEAN PATENT APPLICATION

(11) **EP 1 491 919 A2**
(43) Date of publication of application: **29.12.2004**
(21) Application number: 04014873.6
(22) Date of filing: 24.06.2004
(51) Int. Cl.: G02B 5/04

(54) **Light-emitting apparatus**

(30) Priority: 27.06.2003 JP 2003185073; 28.07.2003 JP 2003202475; 23.10.2003 JP 2003362624
(71) Applicant: Kabushiki Kaisha Toyota Jidoshokki, Kariya-shi, Aichi-ken (JP)
(72) Inventor: Ishikawa, Haruyuki, Kariya-shi Aichi-ken (JP); Tsuzuki, Toshihiko, Kariya-shi Aichi-ken (JP); Takeuchi, Norihito, Kariya-shi Aichi-ken (JP); Yoshida, Mikio, Kariya-shi Aichi-ken (JP)
(74) Representative: Leson, Thomas Johannes Alois, Dipl.-Ing.

(57) **Abstract**

A light extracting sheet is provided on a light extracting surface of an organic EL device. A prism sheet is provided on the light extracting sheet. The light extracting sheet has a first incident surface contacting the light extracting surface and a light exit surface located at an opposite side from the first incident surface. The light exit surface defines a plurality of first projections. Each of the first projections is pyramid. The prism sheet has a second incident surface that is substantially parallel to the light extracting surface and a light exit surface located at an opposite side from the second incident surface. The light exit surface defines a plurality of second projections. Each of the second projections is pyramid.

## Description

### BACKGROUND OF THE INVENTION

The present invention relates to a light-emitting apparatus that includes an optical device for converting the optical path of received light.

Conventionally, there exist area light-emitting devices that has an isotropic light emission property, such as organic electroluminescent devices (organic EL devices) and inorganic electroluminescent devices (inorganic EL devices). Also, lighting apparatuses such as lighting systems and displays using such area light-emitting devices have been proposed.

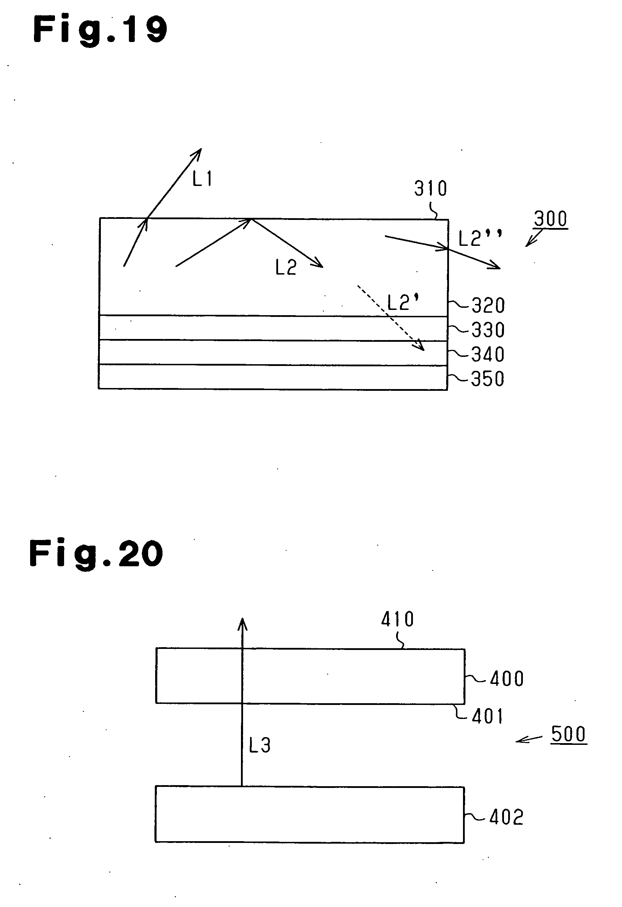

Conventional area light-emitting devices and light-emitting apparatus having area light devices are known for their low extraction efficiency. The reason for this will be explained with reference to Fig. 19.

Fig. 19 shows an organic EL device 300, which is a bottom emission type area light-emitting device. The organic EL device 300 has a transparent substrate 320 having a light extracting surface 310. On the surface opposite from the light extracting surface 310, a transparent electrode 330, an organic layer 340, and a reflecting electrode 350 are successively laminated. Some of light generated by the organic layer 340 passes through the transparent electrode 330 and the transparent substrate 320, and is emitted to the outside of the device from the light extracting surface 310.

Light that is generated by the organic layer 340 and reaches the transparent substrate 320 through the transparent electrode 330 will now be examined. When reaching the light extracting surface 310 at an angle that is smaller than the critical angle of the light extracting surface 310, light is emitted to the outside of the organic EL device 300 (ray L1 in the drawing). On the other hand, then reaching the light extracting surface 310 at an angle that is greater than the critical angle of the light extracting surface 310, light is totally reflected by the light extracting surface 310 (ray L2 in the drawing). In this manner, only some components of light are emitted to the outside through the light extracting surface 310, and the other components of the light are reflected toward the interior of the organic EL device 300. To prevent such reflection, a layer that is located closest to the light extracting side (in this case, the transparent substrate 310) among the materials forming the organic EL device 300 may be made of a material the index of refraction of which is less than that of the outside atmosphere (typically, air). However, such a configuration is practically extremely difficult.

The ray L2 that is totally reflected by the light extracting surface 310 toward the interior of the organic EL device 300 is either attenuated in the organic EL device (ray L2' in the drawing) or emitted to the outside through an edge of the organic EL device 300 (ray L2" in the drawing).

In this manner, only part of the light that is generated by the organic layer 340, or the ray L1, is extracted to the outside of the organic EL device 300 through the light extracting surface 310.

A light-emitting apparatus having the organic EL device 300 cannot achieve a sufficient brightness or consumes an increased amount of electricity to achieve a sufficient brightness.

To eliminate such drawbacks, a technique for forming asperities on a light extracting surface of a transparent substrate of a bottom emission type organic EL device has been proposed (for example, Japanese Laid-Open Patent Publication No. 2000-323272). In this configuration, the ratio of light that is extracted to the outside of the apparatus to light generated by an organic layer (extraction efficiency) is improved.

A sufficient brightness cannot be achieved by applying the above technique, which simply increases the extraction efficiency. That is, light-emitting apparatus are desired to have not only an increased amount of light emitted from the light extracting surface, but also to have an increased brightness in a specific direction with respect to the light extracting surface.

The case of an organic EL device 500 shown in Fig. 20 will be explained as an example. The organic EL device 500 has a transmissive or semitransparent liquid crystal panel 400 and a backlight (light-emitting device) 402. A ray L3 of light generated by the backlight 402 reaches a non-display surface 401 of the liquid crystal panel 400 at an incidence angle of 0°. The incident light containing the ray L3 is used to show images. The organic EL device 500 is desired to have the highest brightness in a direction of the normal to a light extracting surface 410 (front direction).

That is, even if a great amount of light is extracted from an area light-emitting device, the extracted light cannot be used unless the brightness in a specific direction (in the above example, the front direction) is increased.

Accordingly, a light-emitting apparatus is desired not only to increase the extraction efficiency of light generated by an area light-emitting device, but also to permit the extracted light to be effectively used (to increase the utilization factor).

### SUMMARY OF THE INVENTION

Accordingly, it is an objective of the present invention to provide a light-emitting apparatus that has a high extraction efficiency and has a higher brightness in a specific direction than that in other directions.

To achieve the foregoing and other objectives and in accordance with the purpose of the present invention, a light-emitting apparatus having an area light-emitting device, a transparent light extracting member, and a transparent optical device is provided. The area light-emitting device has a light extracting surface. The area light-emitting device has an isotropic light emission property. The transparent light extracting member is provided on the light extracting surface. The light extracting member has a first incident surface contacting the light extracting surface and a light exit surface located at an opposite side from the first incident surface. The light exit surface defines a plurality of first projections and/or first recesses. The first projections project away from the first incident surface, and the first recesses are dented toward the incident surface. Each of the first projections and the first recesses is shaped as n-gonal pyramid or truncated n-gonal pyramid. The pyramid and the truncated pyramid have a bottom that is an imaginary plane substantially parallel to the first incident surface. The optical device is provided on the light extracting member and changes an optical path of light that reaches the device. The optical device has a second incident surface that is substantially parallel to the light extracting surface and a light exit surface located at an opposite side from the second incident surface. The light exit surface defines a plurality of second projections and/or second recesses. The second projections project away from the second incident surface, and the second recesses are dented toward the second incident surface. Each of the second projections and the second recesses is shaped as m-gonal pyramid or truncated m-gonal pyramid. The pyramid and the truncated pyramid have a bottom that is an imaginary plane substantially parallel to the second incident surface. n and m are each a natural number that is greater than three. The numbers n and m satisfy one of the following requirements (i) and (ii): (i) the number n is obtained by multiplying the number m by a natural number; and (ii) the number m is obtained by multiplying the number n by a natural number.

The present invention also provides a light-emitting apparatus having an area light-emitting device, a transparent light extracting member, and a transparent optical device. The area light-emitting device has a light extracting surface. The area light-emitting device has an isotropic light emission property. The light extracting member is provided on the light extracting surface. The light extracting member has a first incident surface contacting the light extracting surface and a light exit surface located at an opposite side from the first incident surface. The light exit surface defines a plurality of first projections and/or first recesses. The first projections project away from the first incident surface, and the first recesses are dented toward the first incident surface. Each of the first projections and the first recesses is shaped as n-gonal pyramid or truncated n-gonal pyramid. The pyramid and truncated pyramid have a bottom that is an imaginary plane substantially parallel to the incident surface. The optical device is provided on the light extracting member, and changes an optical path of light that reaches the device. The optical device has a light exit surface that is substantially parallel to the light extracting surface and a second incident surface located at an opposite side from the light exit surface. The second incident surface defines a plurality of second projections and/or second recesses. The second projections project away from the light exit surface, and the second recesses are dented toward the light exit surface. Each of the second projections and the second recesses is shaped as m-gonal pyramid or truncated m-gonal pyramid. The pyramid and the truncated pyramid has a bottom that is an imaginary plane substantially parallel to the light exit surface. n and m are each a natural number that is greater than three. The numbers n and m satisfy one of the following requirements (i) and (ii): (i) the number n is obtained by multiplying the number m by a natural number; and (ii) the number m is obtained by multiplying the number n by a natural number.

Further, the present invention provides a light-emitting apparatus having an area light-emitting device, a transparent light extracting member, a first optical device, and a second optical device. The area light-emitting device has a light extracting surface. The area light-emitting device has an isotropic light emission property. The light extracting member is provided on the light extracting surface. The light extracting member has a first incident surface contacting the light extracting surface and a light exit surface located at an opposite side from the first incident surface. The light exit surface defines a plurality of first projections and/or first recesses. The first projections project away from the first incident surface, and the first recesses are dented toward the first incident surface. Each of the first projections and the first recesses is shaped as square pyramid or truncated square pyramid. The pyramid and truncated pyramid have a bottom that is an imaginary plane substantially parallel to the first incident surface. The first optical device and the second optical device are provided on the light extracting member. Each optical device changes an optical path of light that reaches the device. Each of the first and second optical devices has a second incident surface that is substantially parallel to the light extracting surface. A plurality of pole shaped unit prisms are arranged at an opposite side from the second incident surface such that the longitudinal axes of the unit prisms are substantially parallel to one another. The first optical device is arranged such that its incident surface faces the light exit surface of the light extracting member. The second optical device is arranged such that its incident surface faces the second incident surface of the first optical device or the unit prisms of the first optical device. The longitudinal axes of the unit prisms provided on the second optical device are substantially perpendicular to the longitudinal axes of the unit prisms provided on the first optical device.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a perspective view for explaining the structure of a backlight according to one embodiment;
Fig. 2 is a cross-sectional view for explaining the structure of the backlight according to this embodiment;
Fig. 3(a) is a plan view illustrating first projections of the backlight according to this embodiment;
Fig. 3(b) is a cross-sectional view taken along line 3b-3b of Fig. 3(a);
Fig. 3(c) is a cross-sectional view taken along line 3c-3c of Fig. 3(a);
Fig. 4(a) is a first diagram illustrating the first projections of the backlight according to this embodiment;
Fig. 4(b) is a cross-sectional view taken along line 4b-4b of Fig. 4(a);
Fig. 4(c) is a cross-sectional view taken along line 4c-4c of Fig. 4(a);
Fig. 4(d) is a second diagram illustrating second projections of the backlight according to this embodiment;
Fig. 4(e) is a cross-sectional view taken along line 4e-4e of Fig. 4(d);
Fig. 4(f) is a cross-sectional view taken along line 4f-4f of Fig. 4(d);
Fig. 5(a) is a second diagram illustrating the first projections of the backlight according to this embodiment;
Fig. 5(b) is a cross-sectional view taken along line 5b-5b of Fig. 5(a);
Fig. 5(c) is a cross-sectional view taken along line 5c-5c of Fig. 5(a);
Fig. 5(d) is a second diagram illustrating second projections of the backlight according to this embodiment;
Fig. 5(e) is a cross-sectional view taken along line 5e-5e of Fig. 5(d);
Fig. 5(f) is a cross-sectional view taken along line 5f-5f of Fig. 5(d);
Fig. 6(a) is a cross-sectional view illustrating one of first projections of a backlight according to a modification of this embodiment, in which the first projections are shaped as equilateral triangular pyramids;
Fig. 6(b) is a cross-sectional view taken along line 6b-6b of Fig. 6(a);
Fig. 6(c) is a cross-sectional view illustrating one of second projections of a backlight according to a modification of this embodiment, in which the second projections are shaped as equilateral triangular pyramids;
Fig. 6(d) is a cross-sectional view taken along line 6d-6d of Fig. 6(c);
Fig. 6(e) is a cross-sectional view illustrating one of second projections of a backlight according to a modification of this embodiment, in which the second projections are shaped as equilateral hexagonal pyramids;
Fig. 6(f) is a cross-sectional view taken along line 6f-6f of Fig. 6(e);
Fig. 7 is a diagram illustrating the backlight of this embodiment, in which the first projections are shaped as equilateral triangular pyramids and are densely provided on a light extracting surface 12;
Fig. 8(a) is a diagram illustrating first projections of a backlight according to another modification of this embodiment;
Fig. 8(b) is a cross-sectional view taken along line 8b-8b of Fig. 8(a);
Fig. 8(c) is a cross-sectional view taken along line 8c-8c of Fig. 8(a);
Fig. 8(d) is a diagram illustrating second projections of a backlight according to another modification of this embodiment;
Fig. 8(e) is a cross-sectional view taken along line 8e-8e of Fig. 8(d);
Fig. 8(f) is a cross-sectional view taken along line 8f-8f of Fig. 8(d);
Fig. 9(a) is a diagram illustrating first projections of a backlight according to another modification of this embodiment;
Fig. 9(b) is a cross-sectional view taken along line 9b-9b of Fig. 9(a);
Fig. 9(c) is a cross-sectional view taken along line 9c-9c of Fig. 9(a);
Fig. 9(d) is a diagram illustrating second projections of a backlight according to another modification of this embodiment;
Fig. 9(e) is a cross-sectional view taken along line 9e-9e of Fig. 9(d);
Fig. 9(f) is a cross-sectional view taken along line 9f-9f of Fig. 9(d);
Fig. 10(a) is a diagram showing a light extracting sheet according to a modification;
Fig. 10(b) is a cross-sectional view taken along line 10b-10b of Fig. 10(a);
Fig. 10(c) is a cross-sectional view taken along line 10c-10c of Fig. 10(a);
Fig. 11(a) is a diagram showing a light extracting sheet according to another modification;
Fig. 11(b) is a cross-sectional view taken along line 11b-11b of Fig. 11(a);
Fig. 11(c) is a cross-sectional view taken along line 11c-11c of Fig. 11(a);
Fig. 12 is a cross-sectional view illustrating a prism sheet according to a modification;
Fig. 13 is a second cross-sectional view illustrating a prism sheet according to another modification;
Fig. 14 is a cross-sectional view illustrating a prism sheet according to another modification;
Fig. 15 is a cross-sectional view illustrating an example in which the light extracting sheet is used as a substrate of an organic EL device;
Fig. 16 is a perspective view for explaining the structure of a backlight according to a second embodiment;
Fig. 17(a) is a diagram for explaining the operation of the backlight according to the second embodiment, using arrows that represent extraction directions of light on the light extracting sheet;
Fig. 17(b) is a cross-sectional view taken along line 17b-17b of Fig. 17(a);
Fig. 17(c) is a cross-sectional view taken along line 17c-17c of Fig. 17(a);
Fig. 18(a) is a second diagram for explaining the operation of the backlight according to the second embodiment, using arrows that represent extraction directions of light on the light extracting sheet;
Fig. 18(b) is a cross-sectional view taken along line 18b-18b of Fig. 18(a);
Fig. 18(c) is a cross-sectional view taken along line 18c-18c of Fig. 18(a);
Fig. 19 is a first cross-sectional view for explaining drawbacks of a prior art; and
Fig. 20 is a second cross-sectional view for explaining drawbacks of the prior art.

### DETAILED DESCRIPTION OF THE PREFERRED EMBODIMENTS

Several embodiments of the present invention will now be described with reference to the drawings. First, a backlight (light-emitting device) of a liquid crystal display according to a first embodiment will be described. In the drawings, the same or like components have the same reference numbers.

### <<First Embodiment>>

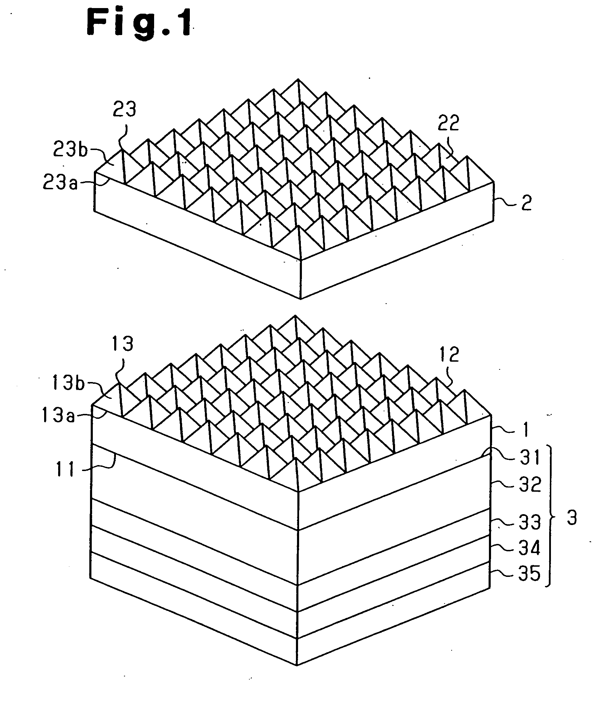

Fig. 1 diagrammatically shows the structure of the backlight of this embodiment.

As shown in Fig. 1, an area light-emitting device, which is an organic EL device 3, has a light extracting surface 31. A light extracting member, which is a light extracting sheet 1, and an optical device, which is prism sheet 2, are provided on the light extracting surface 31.

### <Light Extracting Sheet 1>

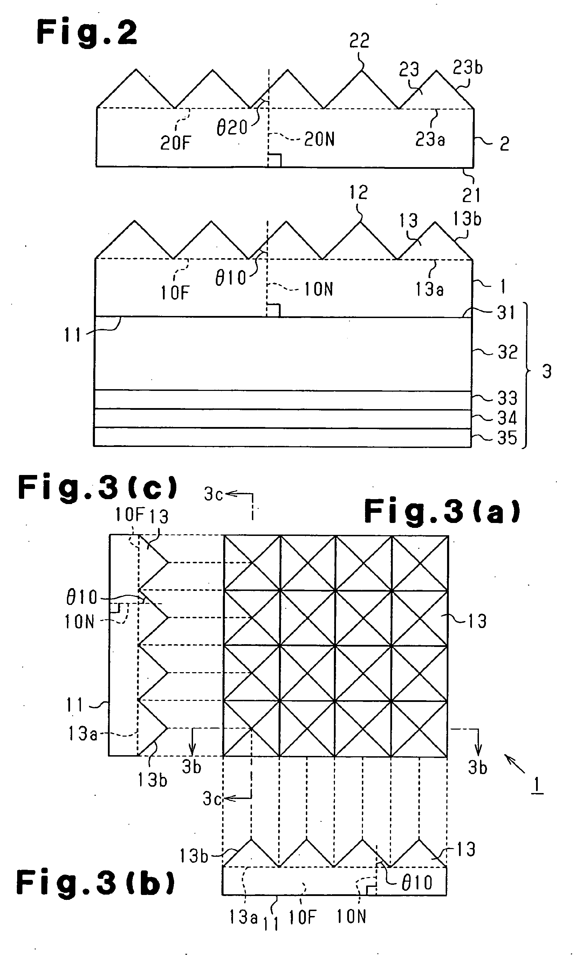

As shown in Figs. 2 and 3, the light extracting sheet 1 has a first incident surface 11 that contacts the light extracting surface 31 of the organic EL device 3. First projections 13 are formed on a side of the light extracting sheet 1 opposite from the first incident surface 11. The first projections 13 are shaped as square pyramids of the same size and shape. A bottom 13a of each first projection 13 is included in an imaginary plane 10F that lies substantially parallel to the first incident surface 11.

With respect to sides defining the bottom 13a of each first projection 13, one of the sides of each first projection 13 is common to a side of one of the adjacent first projections 13. However, since the outermost first projections 13 on the light extracting sheet 1 have no adjacent projections located outward, the outer sides of such first projections 13 are not common to any other first projections 13.

The size of the first projections 13 may be arbitrarily determined. Typically, the first projections 13 are designed such that each side of the bottom 13a is no less than 1 µm and no more than 900 µm long, and the height, or the distance from the bottom 13a to the peak is no less 1 µm and no more than 1200 µm.

As long as the light extracting sheet 1 is transparent to light that is generated by the organic EL device 3 and emitted to the outside form the backlight of this embodiment, the light extracting sheet 1 may be made of any of conventional materials that give transparency to the sheet 1.

The index of refraction of the light extracting sheet 1 is preferably intermediate between the index of refraction of a layer of the organic EL device 3 that is closest to the light extracting side and the index of refraction of the outside atmosphere (typically air). A material having an index of refraction no less than 1.4 and no more than 1.7 is typically used for the light extracting sheet 1.

Alternatively, the light extracting sheet 1 may be formed by laminating layers of the same material or layers of different materials.

Materials satisfying the above requirements include polymethyl-methacrylate (index of refraction n = 1.49), Arton (n = 1.51, registered trademark), Zeonor (n = 1.52, registered trademark), glass (n = 1.53), polyvinyl chloride (n = 1.54), polyethylene terephthalate (n =1.57), polycarbonate (n = 1.58), polystyrene (n = 1.59).

The first projections 13 may be formed by a conventional method. For example the first projections 13 may be formed by any of the following methods.

A method for forming projections by carving a plate formed of any of the above listed materials.

A method for forming projections on a plate formed of any of the above listed materials using masks and photolithography.

A method for producing the light extracting sheet 1 having the projections by preparing a mold for forming projections, pouring any of the above listed materials, and solidifying the material.

The first incident surface 11 of the light extracting sheet 1 and the light extracting surface 31 of the organic EL device 3 are preferably brought into intimate contact with each other. To make the index of refraction of the light extracting sheet 1 intermediate between the index of refraction of a layer of the organic EL device 3 that is closest to the light extracting side and the index of refraction of the outside atmosphere, materials that bring the light extracting sheet 1 and the layer of the organic EL device 3 into intimate contact with each other when heat or ultraviolet light is applied to the materials are selected. Alternatively, the sheet 1 may be adhered to the layer of the organic EL device 3 with an adhesive or an adhesive sheet having the above listed values of index of refraction. The reason why the light extracting sheet 1 and the layer of the organic EL device 3 are preferably brought into intimate contact with each other is that, if, for example, air exists between them in a certain section, the mechanism for extracting light to the outside through the section of the light extracting surface 31 of the organic EL device 3 is the same as that of the prior art.

Providing the light extracting sheet 1 on the light extracting surface 31 of the organic EL device 3 in the above described manner increases the amount of light that is extracted to the outside compared to a case where the sheet 1 is not provided. In other words, the extraction efficiency is improved. For example, since the prior art organic EL device 300 shown in Fig. 19 has the flat light extracting surface 310, only light the incidence angle of which is in a certain range with respect to the normal to the light extracting surface 310 is extracted to the outside. On the other hand, in this embodiment, light in a certain angle range with respect to the normal to the slopes 13b is extracted to the outside. That is, since the slopes 13b are inclined relative to the imaginary plane 10F, the light extracting sheet 1 is capable of emitting light that reaches the imaginary plane 10F at an angle greater than the critical angle of the light extracting surface 310 of the organic EL device 300. Further, in this embodiment, each first projection 13 has four slopes 13b and the total area of these slopes 13b is greater than the area of the bottom 13a. Therefore, the backlight of this embodiment has a higher extraction efficiency than prior art backlights.

### (Prism Sheet 2)

In this embodiment, the prism sheet 2 has the identical shape with that of the light extracting sheet 1. That is, the prism sheet 2 is identical with the light extracting sheet 1 shown in Figs. 2 to 3(c), and, in the drawings, the following elements are the same.

A second incident surface 21 is identical with the first incident surface 11.

Second projections 23 are identical with the first projections 13.

An imaginary plane 20F including bottoms 23a of the second projections 23 is identical with the imaginary plane 10F including the bottoms 13a of the first projections 13.

A normal 20N to the second incident surface 21 is identical to a normal 10N to the first incident surface 11.

An angle θ20 defined by the normal 20N and a slope 23b of each second projection is identical with an angle θ10 defined by the normal 10N and the slope 13b of each first projection. More specifically, the prism sheet 2 has a shape as shown in Fig. 2. The prism sheet 2 has the second incident surface 21, which is substantially parallel to the light extracting surface 31 of the organic EL device 3. Second projections 23 are formed on a side of the prism sheet 2 opposite from the second incident surface 21. A bottom 23a of each second projection 23 is included in the imaginary plane 20F that lies substantially parallel to the second incident surface 21.

The prism sheet 2 is formed the same material as the light extracting sheet 1 and produced to have the same shape (size) as the sheet 1 by the same producing method.

The angle θ10 defined by each slope 13b of the first projections 13 on the light extracting sheet 1 and the normal 10N to the first incident surface 11 is substantially equal to the angle θ20 defined by each slope 23b of the second projections 23 on the prism sheet 2 and the normal 20N to the second incident surface 21.

In this specification, the angle defined by a normal and a slope refers to the smallest angle that is defined by the normal and the slope. In other words, the angle refers to an angle defined by a normal and a line that contains the peak of the projection and is perpendicular to a side of the bottom.

The size of the second projections 23 on the prism sheet 2 is the same as the size of the first projections 13 on the light extracting surface 1.

The prism sheet 2 is arranged such that a line that includes the peaks of an adjacent pair of the first projections 13 is parallel to a line that includes the peaks of an adjacent pair of the second projections 23. In other words, the prism sheet 2 is arranged such that the direction along which the second projections 23 are arranged substantially coincides with the direction along which the first projections 13 are arranged.

When viewed from the direction of the normal 20N to the second incident surface 21 of the prism sheet 2 (that is, as viewed from the direction of the normal 10N to the first incident surface 11 of the light extracting sheet 1), the positions of the peaks of the first projections 13 are aligned with the positions of the peaks of the second projections 23. The positions of the peaks need not be aligned.

In this embodiment, the prism sheet 2 has the same index of refraction as the light extracting sheet 1.

The distance between the prism sheet 2 and the light extracting sheet 1 is set to a predetermined value.

### <Organic EL Device 3>

As shown in Fig. 2, a transparent electrode 33, an organic layer 34 and a reflecting electrode 35 are successively formed on a transparent substrate 32 of the organic EL device 3. The transparent substrate 32 is made of glass or resin. The transparent electrode 33 is formed of ITO or IZO. The organic layer 34 contains an organic light-emitting material, which is for example, a poly-para-phenylene vinylene derivative such as Alq3, DPVBi, EM2, P1, DSA, tBu-PTC, CN-PPV, a polythiophene derivative such as PTOPT, a poly-para-phenylene derivative such as PO-PPP, a polyacethylene derivative such as PDPA. The reflecting electrode 35 is formed of aluminum or chromium.

The configuration and the materials of the layers of the organic EL device are not limited to the ones listed above. Techniques used for conventional organic EL devices may be used as necessary. For example. an additional layer having a property for injecting or transporting carriers (holes, electrons) may formed. Also, the organic EL device may be covered with a passivation film. Further, the above described layers may be laminated.

The organic EL device 3 may be produced by a method for producing conventional organic EL devices. For example, the organic EL device 3 may be formed by vacuum deposition, sputtering, ionized deposition, or an inkjet method.

### <Mechanisms, Operation>

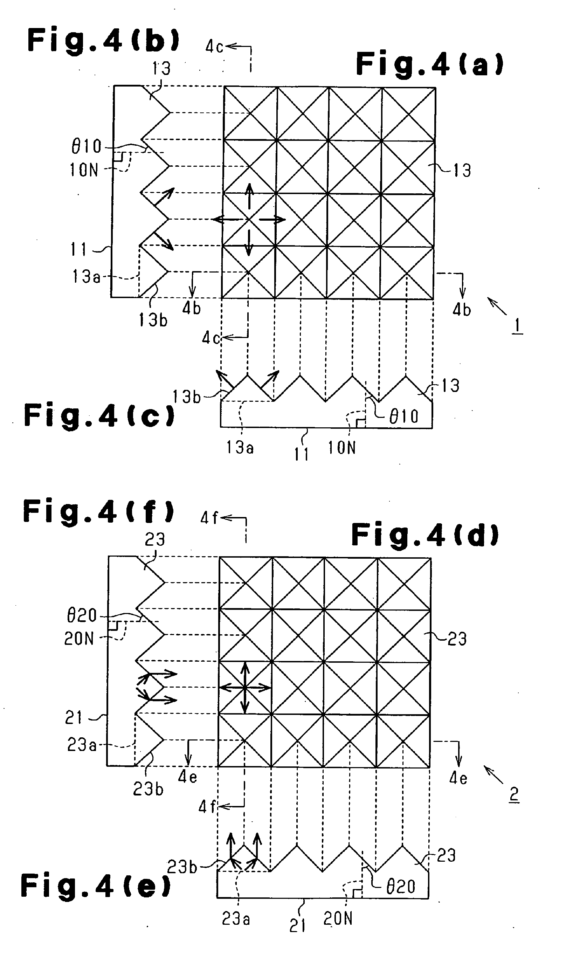

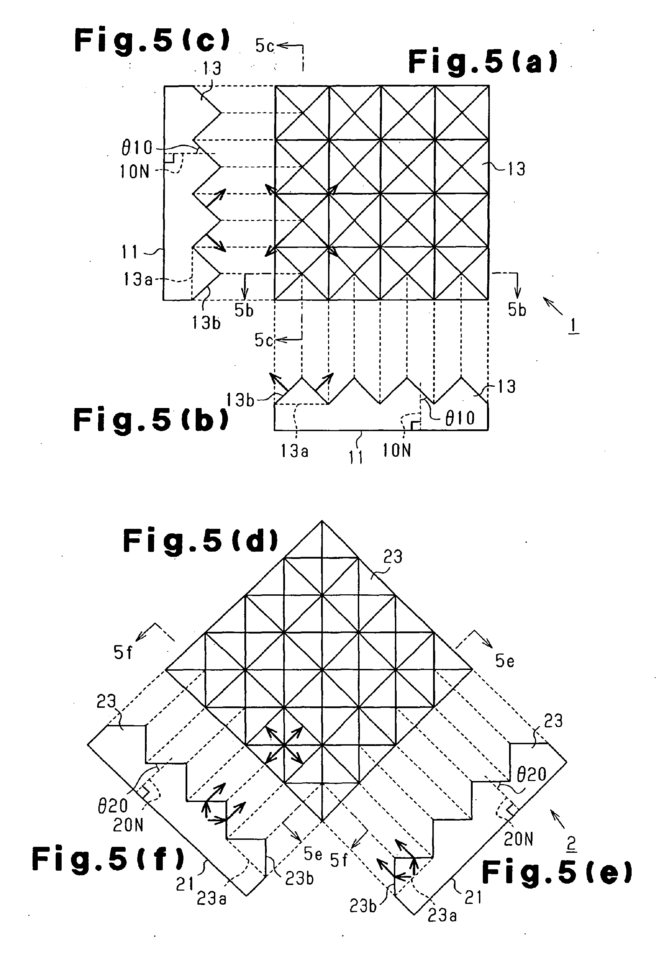

Referring to Figs. 4(a) to 5(f), a mechanism for significantly increasing the front brightness of the above described backlight will be explained. In the drawings, arrows of thick solid lines represent advancing directions of light. Referring to Figs. 4(a) to 4(f), a first mechanism for increasing the front brightness will be explained.

In this embodiment, the light extracting sheet 1 and the organic EL device 3 are provided in a state where the sheet 1 and device 3 intimately contact each other. Therefore, as shown in Figs. 2 and 4(a) to 4(c), the amount of light that is emitted in a direction perpendicular to the slopes 13b of the first projections is greater than that of the conventional apparatus shown in Figs. 19 and 20. When light that is emitted from each slope 13b is projected onto a plane that is substantially parallel to the first incident surface 11, the brightness in a direction perpendicular to the slope 13b is higher than the brightness in other directions on the plane.

Light that exits the light extracting sheet 1 enters the prism sheet 2. Then, as shown in Figs. 4(d) to 4(f), the advancing direction of light that reaches a slope 23b of the second projections 23 on the prism sheet 2 in a direction perpendicular to the slope 23b is changed to a direction of the normal to the second incident surface 21, or to the front direction.

On the other hand, the prism sheet 2 is arranged such that a line that includes the peaks of an adjacent pair of the projections 23 is substantially parallel to a line that includes the peaks of an adjacent pair of the projections 13 on the light extracting sheet 1. Therefore, as represented by bold arrows in Fig. 4(a), the advancing directions of rays of light that have advanced in four different directions are converted into the front direction as shown in Figs. 4(d) to 4(f).

In summary, since the amount of light that is emitted in the four directions from the light extracting sheet 1 is greater than the amount of light that is emitted in other directions, and the prism sheet 2 converts the optical paths of the light in the four directions to the front direction, the amount of light emitted in the front direction form the prism sheet 2 is significantly greater than the amount of light emitted in other directions. That is, not only the extraction efficiency, but also the efficiency of use of light is significantly improved in the light-emitting device, or the backlight.

Referring to Figs. 5(a) to 5(f), other examples of configurations and mechanisms for increasing the front brightness of the backlight of this embodiment will no be explained.

Through ray tracking simulations by Monte Carlo method, it was found out that, depending on the angle θ10 defined by the slope 13b of each first projection 13 and the normal 10N to the first incident surface 11, the amount of light that advances along sides of the slopes 13b of the first projections 13 is increased on a plane substantially parallel to the first incident surface 11 as shown in Figs. 5(a) to 5(c). That is, when emitted light emitted is projected onto the plane, the amount of light that advances along the directions of the sides projected onto the plane is increased.

In a plane that is substantially parallel to the second incident surface 21, the prism sheet 2 changes the direction of a component of light that reaches a line of intersection of a slope 23b and the plane substantially at an right angle to the front direction (the direction of the normal 20N to the incident surface).

Therefore, if the prism sheet 2 is arranged such that a line including the peaks of an adjacent pair of the second projections 23 is at 45° relative to a line that includes the peaks of an adjacent pair of the first projections 13 on the light extracting sheet 1, the advancing directions of light emitted in the four directions of the light extracting surface 12 are changed to the front direction as in the above case.

### <Advantages>

The backlight according to the embodiment of Figs. 1 to 5(f) has the light extracting sheet 1 closely contacting the light extracting surface 31 of the organic EL device 3 that has an isotropic light emission property. Also, the light extracting sheet 1 having the first projections 13 and the prism sheet 2 having the second projections 23 are provided over the light extracting surface 31. This configuration significantly increases the front brightness compared to the conventional light-emitting apparatus shown in Figs. 19 and 20.

Since light extracting sheet 1 and the prism sheet 2 are identical, the sheets 1, 2 do not need to be designed and produced separately. This simplifies the production processes.

### <Modifications>

The backlight according to the first embodiment may be modified as follows. The modifications below may be combined as long as they do not conflict with each other.

### (Modification 1: Differentiate Indexes of Refraction of Light Extracting Sheet 1 and Prism Sheet 2)

In the first embodiment, the light extracting sheet 1 and the prism sheet 2 may have different indexes of refraction.

If the sheets 1, 2 have different indexes of refraction and simulations according to Snell laws of refraction are performed, the light extracting sheet 1 and/or the prism sheet 2 can be formed thinner. This, in turn, reduces the thickness of the backlight. Alternatively, the front brightness can be further increased.

That is, since each second projections 23 on the prism sheet 2 has slopes 23b that are inclined relative to the second incident surface 21, light that enters the prism sheet through the second incident surface 21 is refracted to advance in a specific direction, for example, in the direction of the normal to the second incident surface 21. Accordingly, the brightness in this direction is increased.

### (Modification 2: Differentiate Angle θ10 and Angle θ20 of Slopes)

The angle θ10 defined by the normal 10N and each slope 13b of the projections on the light extracting sheet 1 may be different from the angle θ20 defined by the normal 20N and each slope 23b of the projections on the prism sheet 2.

At this time, the angles θ10, θ20 are optimized for increasing the front brightness. Alternatively, if angles θ10, θ20 are set to reduce the thickness of the sheets 1, 2, the light extracting sheet 1 and/or the prism sheet 2 are made thinner. This, in turn, reduces the thickness of the backlight. Alternatively, the front brightness can be further increased.

The sizes and the shapes of the first and second projections 13, 23 may be changed. Accordingly, the light extracting sheet 1 and/or the prism sheet 2 can be formed thinner. This, in turn, reduces the thickness of the backlight. Alternatively, the front brightness can be further increased.

### (Modification 3: Projections of Pyramid other than Square Pyramid)

The first projections 13 and/or the second projections 23 may be pyramids other than square pyramids.

If the first projections are equilateral pyramids each having sides the number of which is n (n is a natural number no less than three), and the second projections 23 are equilateral pyramids each having sides the number of which is m (m is a natural number no less than three), the numbers n and m preferably satisfy one of the following requirements (1) and (2).
(1) The number n is a number obtained by multiplying the number m by a natural number.
(2) The number m is a number obtained by multiplying the number n by a natural number.

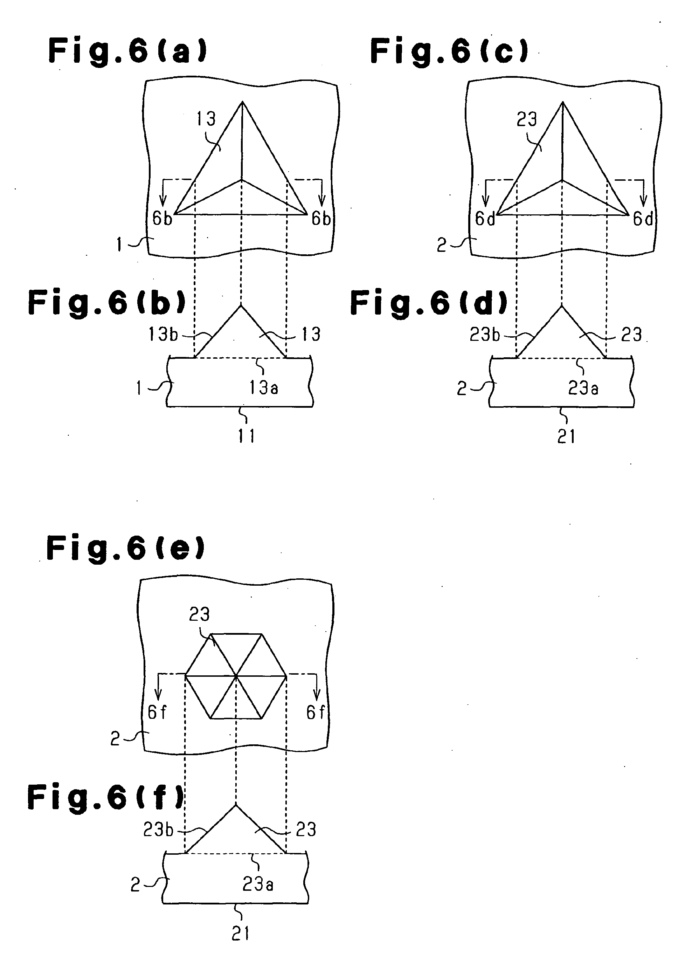

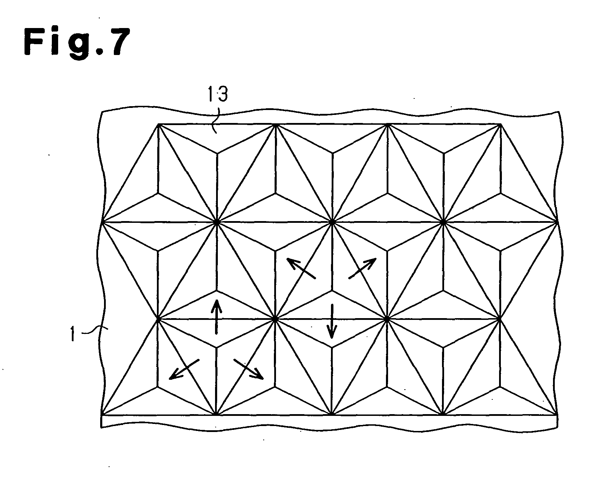

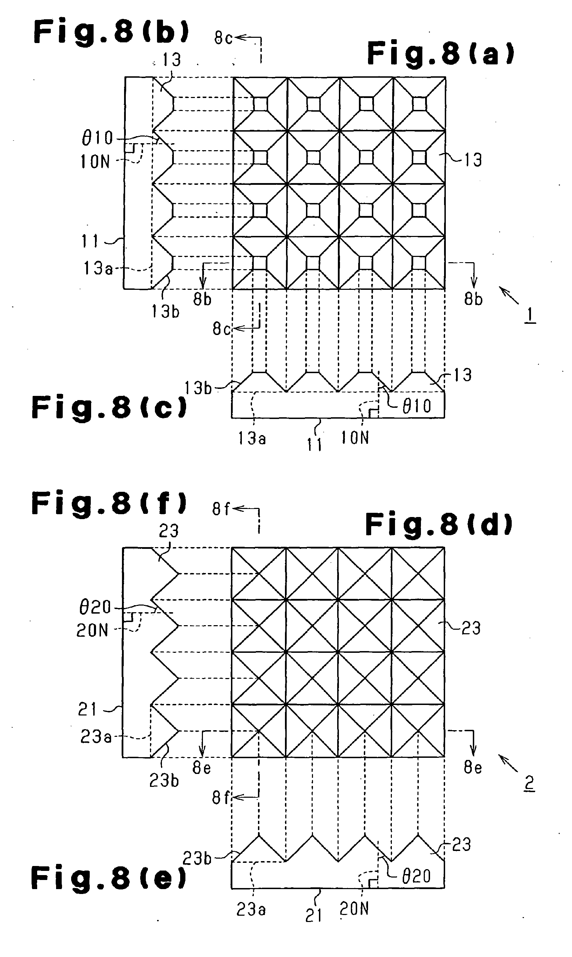

For example, when the first projections 13 are equilateral triangular pyramids as shown in Fig. 6(a), the second projections 23 are preferably equilateral triangular pyramids as shown in Fig. 6(c) or equilateral hexagonal pyramids as shown in Fig. 6(e). Even if the projections 13, 23 have these shapes, a great amount of light is emitted in directions perpendicular to lines of intersections between the slopes 13b and a plane that is substantially parallel to the first incident surface 11, as obvious in the above described mechanisms. That is, in the plane in the light extracting surface 12, a significantly great amount of light is emitted in three direction. Thus, to gather the light and emit in the front direction, the prism sheet 2 preferably has slopes that correspond to the directions of light so that the brightness in a specific direction such as the front direction is sufficiently increased.

As described above, depending on the angle θ10 defined by the slope 13b of each first projection 13 and the normal 10N to the first incident surface 11, the amount of light that advances along the sides of the first projections 13 is increased on a plane substantially parallel to the first incident surface 11. Therefore, if the orientation of the prism sheet 2 is appropriately set according to this characteristics, the front brightness is increased.

Further, when projections 13 shaped like equilateral triangular pyramids are densely formed on the light extracting sheet 1 as shown in Fig. 7, projections 23 shaped like equilateral triangular pyramids or equilateral hexagonal pyramids are preferably densely formed on the prism sheet 2.

For example, when the equilateral triangular projections 13 are densely formed on the light extracting sheet 1, triangles and inverted triangles are arranged on the sheet 1 when viewed from the front as shown in Fig. 7. Thus, as represented by six solid lines with arrows in Fig. 7, the amount of advancing in six directions is increased. Light in the six directions is gathered in this manner to significantly increase the front brightness.

Further, regarding equilateral n-gonal pyramids and m-gonal pyramids, the numbers n and m are preferably three, four, or six so that the first projections 13 and the second projections 23 can be densely arranged. This promotes the above described advantages.

When embodiments other the ones described above are applied, light in a direction along which a great amount of light is emitted through a plane perpendicular to the first incident surface 11 is actually measured. Also, measurement and simulation of the orientation of the prism sheet 2 that effectively increases the brightness in the front direction are preferably performed according'to this direction. Also, when the brightness in a direction other than front direction is increased, the design is altered as necessary. The same is true for the modifications described below.

### (Modification 4: Truncated Equilateral Polygonal Pyramids)

At least one of the first projections 13 and the second projections 23 may be formed as truncated equilateral polygonal pyramids. Alternatively, the first projections 13 and the second projections 23 may be formed as truncated equilateral polygonal pyramids.

Since the upper surface of each truncated pyramid permits part of light in a direction perpendicular to the light extracting surface to pass through without refracting the light toward other directions, truncated pyramids contributes to improvement of the front brightness. Therefore, even if the projections 13, 23 are shaped like truncated equilateral polygonal pyramids, the same advantages as described above are obtained.

For example, the first projections 13 may be shaped as truncated square pyramids as shown in Figs. 8(a) to 8(c), and the second projections 23 may be shaped as square pyramids as shown in Figs. 8(d) to 8(f).

If the projections are equilateral n-gonal pyramids and equilateral m-gonal pyramids, the shapes of the first projections 13 and the second projections 23 need to satisfy one of the following requirements (1) and (2) for the reasons shown above.
(1) The number n is a number obtained by multiplying the number m by a natural number.
(2) The number m is a number obtained by multiplying the number n by a natural number.

### (Modification 5: Projections Shaped Like Unequilateral Polygonal Pyramids or Unequilateral Polygonal Truncated Pyramids)

Projections having unequilateral polygonal based may be formed on the sheets.

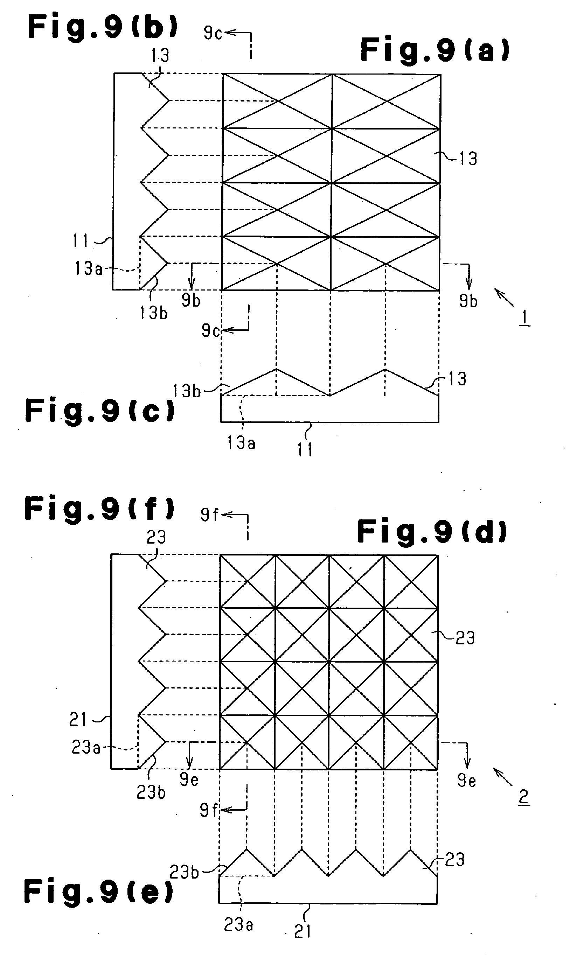

For example, as shown in Figs. 9(a) to 9(c), first projections 13 that are shaped as rectangular pyramids with rectangular bottoms may be formed on the light extracting sheet 1, and, as shown Figs 9(d) to 9(f), second projections 23 that are shaped as square pyramids with square bottoms may be formed on the prism sheet 2.

In this manner, one of the sides of each projection may have a different length from the lengths of the other sides. That is, even if the projections are not shaped as equilateral polygonal pyramids having sides the number of which is n (m), in which the lengths of the sides are equal, the same advantages are obtained as long as the indexes of refraction of the sheets 1, 2 are properly selected, the distance between the sheets 1, 2 is properly determined, or the sizes of the projections 13, 23 are properly determined. This is because the first projections 13 are inclined with respect to the first incident surface 11, and the second projections 23 are inclined with respect to the second incident surface 21.

In order that the prism sheet 2 be capable of changing the optical paths of a great amount of light in the light emitted by the light extracting sheet 1 to the front direction, the sheets need to be designed to satisfy one of the following requirements.
(1) The number n is a number obtained by multiplying the number m by a natural number.
(2) The number m is a number obtained by multiplying the number n by a natural number.

In this case, if the numbers n and m are three, four, or six, the first projections 13 and the second projections 23 can be densely arranged, and therefore the above described advantages are promoted compared to cases where the number n and m have values other than three, four, and six.

In this modification, if the shapes of the pyramids or the truncated pyramids are properly designed, it is possible to provide a backlight that has an increased brightness in a direction other than the front direction or a backlight that has a higher brightness in two or more specific directions than other directions.

That is, since the light extracting sheets 1 has slopes that are located on the light extracting side and inclined relative to the first incident surface 11, and the prism sheet 2 has slopes that are inclined relative to the first incident surface 11 (second incident surface 21), the brightness in one or more specific directions are increased. Further, as described above, since the projections 13 on the light extracting sheet 1 are shaped like pyramids or truncated pyramids, the extraction efficiency is higher than that of the conventional organic EL device.

The bottom of the second projections 23 on the prism sheet 2 may be rectangular. The shapes of the bottoms of the first and second projections 13, 23 do not need to be square or rectangular.

### (Modification 6: Densely Arrange Projections Only on One sheet/ Projections not Covering Entire Surface)

On one of the sheets 1, 2, the projections may be arranged not to cover the entire surface. Alternatively, both on the sheets 1, 2, the projections may be arranged not to cover the entire surface. This modification is possible because the above described advantages are obtained by the slopes 13b or 23b, which are inclined relative to the first incident surface 11 or the second incident surface 21, respectively.

### (Modification 7: Form Recesses instead of Projections on One of Sheets or on Both Sheets)

Instead of forming projections, recesses may be formed on one of the light extracting sheet 1 and the prism sheet 2. Recesses may be formed on both of the light extracting sheet 1 and the prism sheet 2.

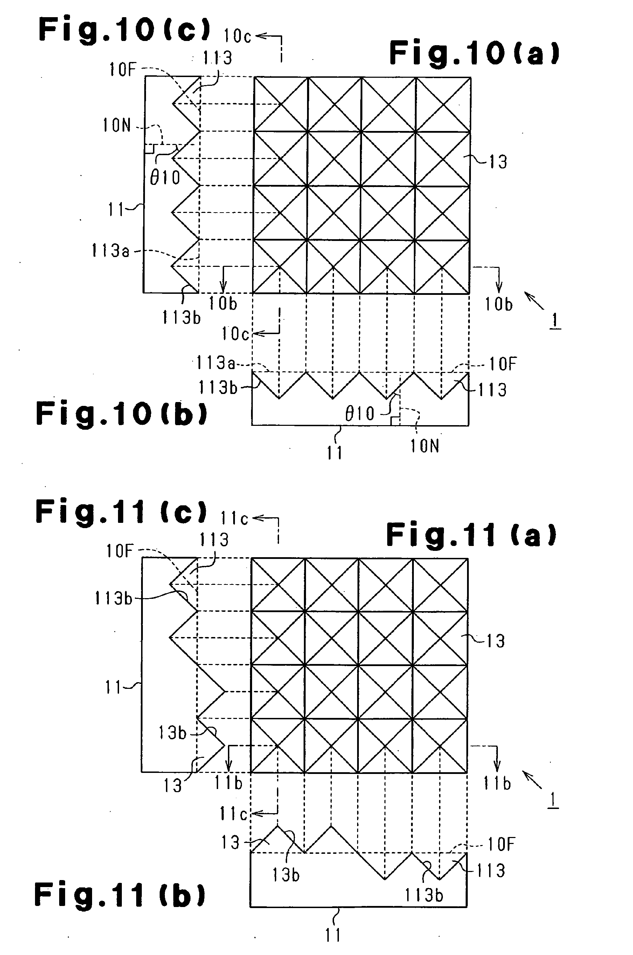

For example, as shown in Figs. 10(a) to 10(c), square pyramid shaped first recesses 113 are formed in the light extracting sheet 1. Each first recess 113 is deepened toward the first incident surface 11. Each first recess 113 is defined by slopes 113b that are inclined relative to the first incident surface 11. A bottom 113a of each first recess 113 is located in an imaginary plane that lies substantially parallel to the first incident surface 11. The sides of each first recess 113 does not need to be equal. That is, the first recesses 113 may be shaped like pyramids or truncated pyramids having sides of different lengths. Since the light extracting sheet 1 has the slopes 113b, which are inclined relative to the first incident surface 11, the same advantages are obtained as in the embodiments of Figs. 1 to 9(f).

Instead of the second projections 23, second recesses 123 that are deepened toward the second incident surface 21 may be formed on the prism sheet 2. Alternatively, instead of the projections, the recesses 113, 123 may be formed on the sheets 1, 2, respectively.

### (Modification 8: Sheet having Projections and Recesses)

On one or both of the light extracting sheet 1 and the prism sheet 2, both projections and recesses are formed.

For example, as shown in Figs. 11(a) to 11(c), the first projections 13 and the first recesses 113 are formed in a mixed state in the light extracting sheet 1. This modification has the same advantages as the above embodiment.

### (Modification 9: Change Side of Prism Sheet 2 on which Second Projections and/or Second Recesses on Different Side are Formed)

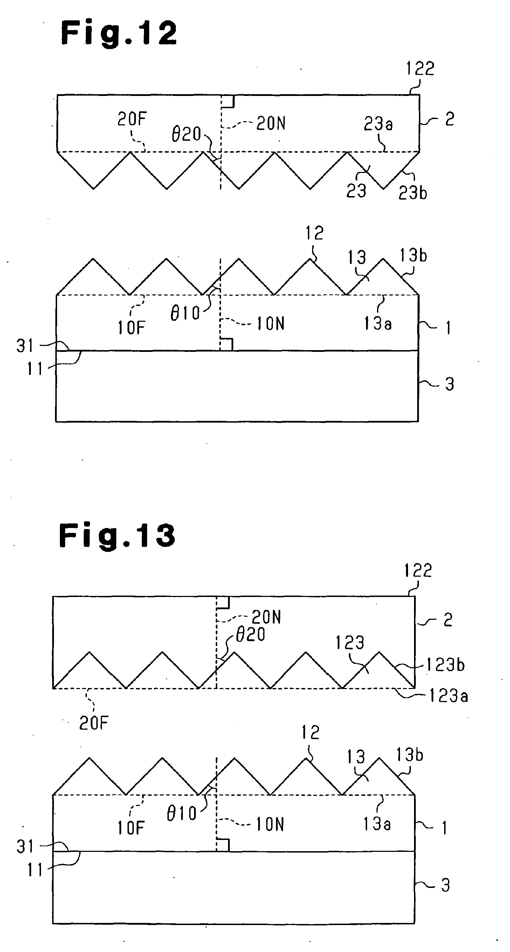

Fig. 12 illustrates a modification in which a side of the prism sheet 2 on which the second projections 23 are formed is changed. As shown in Fig. 2, the second projections 23 are formed on the prism sheet 2 to face the first projections 13 on the light extracting sheet 1. Light that reaches the prism sheet 2 from the light extracting sheet 1 is refracted toward the light exit surface 122 by the slopes 23b and emitted in a specific direction such as a direction of the normal to the light exit surface 122. The sheet 2 of this modification has the same advantages as the above embodiment.

Fig. 13 illustrates the prism sheet 2 in which the second recesses 123 are formed to face the first projections 13 on the light extracting sheet 1. The sheet 2 of this modification has the same advantages as the above embodiment. Further, even if the second projections 23 and the second recesses 123 are formed in a mixed state in the prism sheet 2 of this modification, the same advantages as described above are obtained.

### (Modification 10: Form Second Projections on Both Sides of Prism Sheet 2)

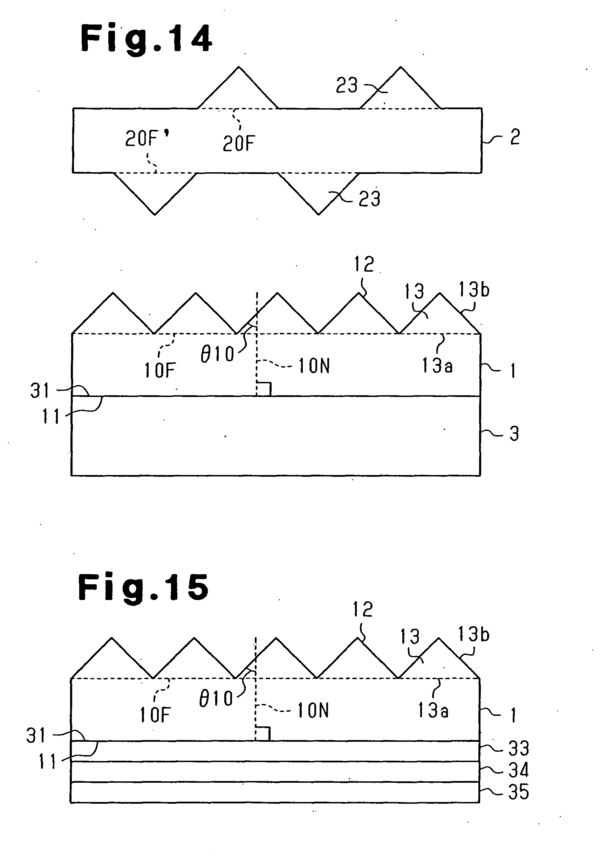

As shown in Fig. 14, the second projections 23 may be formed on both faces (both sides) of the prism sheet 2. Since each second projection 23 has the slopes 23b, the same advantages as described above are obtained.

In the embodiment of Fig. 14, the second projections 23 may be replaced by the second recesses 123. Further, even if the second projections 23 and the second recesses 123 are formed in a mixed state in the prism sheet 2 of this modification, the same advantages as described above are obtained.

### (Modification 11: Use Light Extracting Sheet 1 as Substrate of Organic EL Device 3)

In the backlight, the light extracting sheet 1 may be used as the substrate of the organic EL device 3.

For example, as shown in Fig. 15, layers forming the organic EL device 3 (for example, the transparent electrode 33, the organic layer 34, and the reflecting electrode 35) may be formed on the first incident surface 11 of the light extracting sheet 1.

In this configuration, since a common member is used for the substrate of the organic EL device 3 and the light extraction sheet 1, the thickness of the backlight is reduced. Also, attenuation of light in the transparent substrate is reduced.

Also, the same advantages as described above are obtained even if, after the organic EL device 3 is formed, one or both of the first projections 13 and the first recesses 113 are formed on the surface of a layer of the organic EL device 3 that is closest to the light extracting side.

In this case, after providing the organic layer 33 of the organic EL device 3 with protection, one or both of the first projections 13 and the first recesses 113 are formed by a conventional method for machining substrates.

### <Modification 12: Use of Other Types of Area Light-Emitting Device>

Instead of the organic EL device 3, an area light-emitting device or an inorganic EL device including an optical waveguide and a cold cathode tube may be employed.

### (Modification 13: Apply Invention to Apparatuses other than Backlight)

The above described backlights are designed for liquid crystal displays. However, the present invention may be applied to other purposes. For example, the present invention may be applied to lighting systems.

The organic EL device (area light-emitting device) may be configured to display imagery. For example, conventional drive circuit of a passive or active matrix system may be incorporated in the organic EL device to allow the device to display imagery. In this case, the imagery is clearly visible in a specific direction.

### (Modification 14: Change Arrangement of Prism Sheet 2 relative to Light Extracting Sheet 1)

The arrangement of the prism sheet 2 to the light extracting sheet 1 is not limited to those in the embodiments of Figs. 1 to 15, but may be changed.

For example, in the embodiment of Fig. 2, the prism sheet 2 may be arranged relative to the light extracting sheet 1 such that a line that includes the peaks of an adjacent pair of the first projections 13 is not substantially parallel to a line that includes the peaks of an adjacent pair of the second projections 23. Also, the second incident surface 21 of the light exit surface 122 may be arranged substantially not parallel to the first incident surface 11. This modification also provides a backlight that has an increased brightness in a direction other than the front direction or a backlight that has a higher brightness in two or more specific directions than other directions.

The prism sheet 2 may be spaced by the light extracting sheet 1 by a predetermined distance. Alternatively, the prism sheet 2 may be arranged such that part of the sheet 2 contacts the light extracting sheet 1.

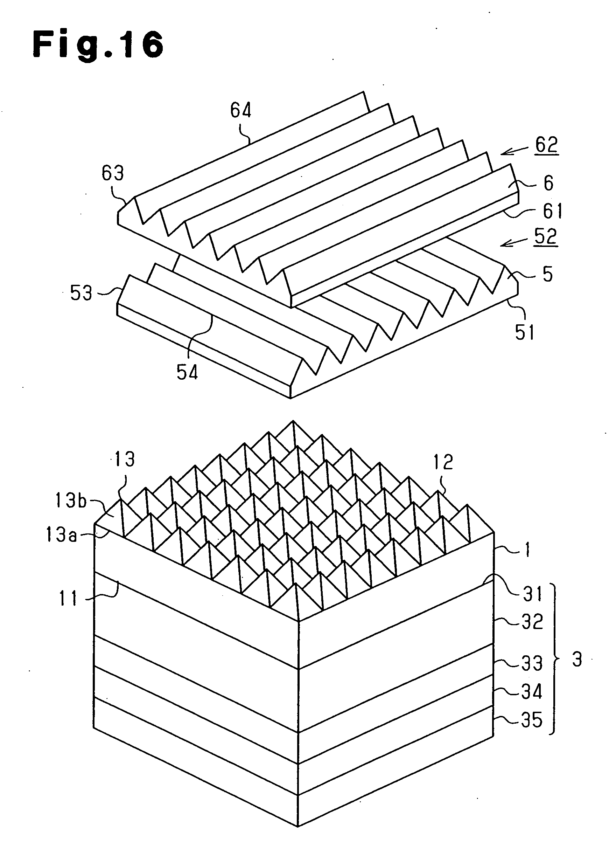

Next, a backlight (light-emitting device) of a liquid crystal display according to a second embodiment will be described with reference to Figs. 16 to 18. Like or the same reference numerals are given to those components in Figs. 16 to 18 that are like or the same as the corresponding components in Figs. 1 to 15.

### <<Second Embodiment>>

As shown in Fig. 16, a backlight according to the second embodiment has the light extracting sheet 1 provided on the light extracting surface 31 of the organic EL device 3. A first optical device, which is a first prism sheet 5, is provided on the light extracting sheet 1. A second optical device, which is a second prism sheet 6, is provided on the first prism sheet 5.

The organic EL device 3 and the light extracting sheet 1 of this embodiment are the same as those of the first embodiment except that one or both of projections and recesses on the light extracting sheet 1 are shaped like rectangular pyramids or rectangular truncated pyramids. Also, since the organic EL device 3 and the light extracting sheet 1 of this embodiment may be modified in the same ways as the first embodiment, descriptions regarding those modifications of the second embodiment are omitted. Hereinafter, the mechanism (operation) of the prism sheet 5, 6 and the backlight according to the second embodiment will be described.

### <Prism Sheets 5, 6>

As shown in Fig. 16, the first prism sheet 5 has a second incident surface 51. On a side opposite from the second incident surface 51, or on a light exit surface 52, first prism portions 53 that are shaped like triangle poles are formed. The first prism portions 53 are arranged such that longitudinal axes 54 of the prism portions 53 are parallel to on another.

The second prism sheet 6 has a third incident surface 61 facing the first prism portions 53. On a side opposite from the third incident surface 61, or on a light exit surface 62, second prism portions 63 that are shaped like triangle poles are formed. The second prism portions 63 are arranged such that longitudinal axes 64 of the prism portions 63 are parallel to on another.

The first prism sheet 5 is arranged such that first projections 13 formed on the light extracting sheet 1 face the second incident surface 51. The second prism sheet 6 is arranged such that the first prism portions 53 of the first prism sheet 5 face the third incident surface 61. The second incident surface 51 of the first prism sheet 5 and the third incident surface 61 of the second prism sheet 6 are each arranged to be parallel to the first incident surface 11 of the light extracting sheet 1. The second prism sheet 6 is arranged relative to the first prism sheet 5 such that the longitudinal axes 64 of the second prism portions 63 are substantially perpendicular to the longitudinal axes 54 of the first prism sheet 53.

The first prism sheet 5 and the second prism sheet 6 need to have at least transparency to the wavelengths of light generated by the backlight. Therefore, materials listed for forming the light extracting sheet 1 shown in Fig. 1 and other materials for forming conventional prism sheet may be used as necessary. The first and second prism sheet 5, 6 may be formed by the above described method or by any conventional method for forming prism sheets.

The backlight according to the second embodiment, which is configured as described above, has the following mechanism and has the same operations and advantages as the backlight according to the first embodiment shown in Figs. 1 to 15.

### <Mechanisms, Operation>

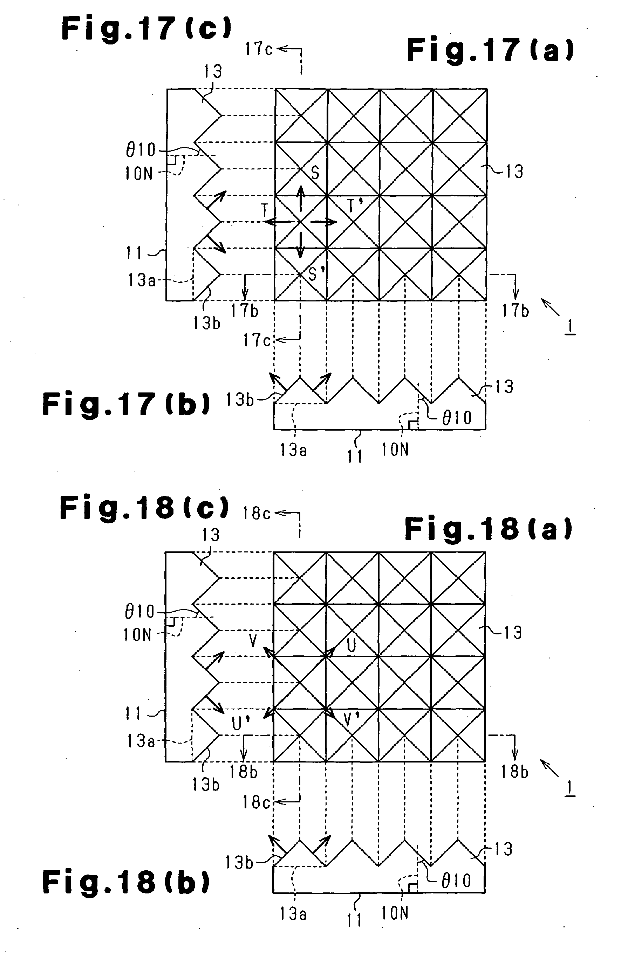

In Figs. 17(a) to 17(c), light extracting directions of the light extracting sheet 1 (directions in which the amount of extracted light is great) are represented by arrows.

As described above, in an imaginary plane that is substantially perpendicular to the first incident surface 11, the amount of light that is emitted in directions perpendicular to the slopes 13b of the first projections 13 is increased compared to the prior art. That is, when light emitted from the slopes 13b is projected on the imaginary plane, the brightness in a direction S, a direction S', and a direction T' on the imaginary plane is greater than the brightness in other directions.

Further, depending on the angle θ10 defined by the slope 13b of each first projection 13 and the normal 10N to the first incident surface 11, the amount of light that advances along directions of extended sides defining the slopes 13b of the first projections 13 is increased on an imaginary plane substantially parallel to the first incident surface 11. That is, as shown in Figs. 18(a) to 18(c), the brightness in a direction U, a direction U', a direction V, and a direction V' is greater than the brightness in other directions.

In this manner, when the light emitted by the light extracting sheet 1 is projected on to the imaginary plane substantially perpendicular to the first incident surface 11, the amount of light in four directions that are perpendicular or opposite to one another.

The first prism sheet 5 and the second prism sheet 6 convert the light advancing the four directions to light advancing in the front direction. Therefore, as the backlight according to the first embodiment, the brightness in the front direction is increased compared to the brightness in other directions. That is, not only the extraction efficiency, but also the efficiency of use of light is significantly improved in the backlight.

The first prism sheet 5 is typically arranged such that the second incident surface 51 is parallel to the first incident surface 11 of the light extracting sheet 1. The longitudinal axes 54 of the prism portions 53 are inclined approximately by 45° relative to the direction S, the direction T, the direction U, or the direction V. Preferably, the longitudinal axes 54 are inclined in a range ±3° of 45° relative to direction S, T, U or V. This configuration significantly increases the brightness in the front direction.

### <Modifications>

The backlight according to the second embodiment may be modified as follows. The modifications below may be combined as long as they do not conflict with each other.

The backlight according to the second embodiment may be combined with any of the modifications of the backlight according to the first embodiment.

### (Modification 15: Arrange Prism Portions 53, 63 to Face Light Extracting Sheet 1)

The positions of the prism sheet 5, 6 shown in Fig. 16 may be switched. This configuration has substantially the same operations and advantages as described above for the same reasons described above.

### (Modification 16: Arrange Prism Portions 53, 63 on Prism Sheets 5, 6 to Face Each Other/ to Face Away From Each Other)

Unlike Modification 15, the prism portions 53 on the first prism sheet 5 and the prism portions 63 on the second prism sheet 6 may be arranged to face each other. Alternatively, the prism portions 53, 63 may be arranged to face away (in opposite directions) from each other. This configuration also provides the same operations and advantages as described above.

The prism portions 53 may be provided on both sides of the first prism sheet 5. Alternatively, the prism portions 63 may be provided on both sides of the second prism sheet 6. Further, the prism portions 53 and the prism portions 63 may be provided on both sides of the first and second prism sheets 5, 6, respectively.

### (Modification 17: Form Prism Portions 53, 63 with Recesses instead of Projections)

The prism portions 53, 63 may be recesses each of which is deepened toward the corresponding one of the incident surfaces 51, 61. Only the prism portions 53 or the prism portions 63 may be recesses. Alternatively, both of the prism portions 53, 63 may be recesses.

### (Modification 18: Prism Portions 53, 63 having Shapes other than Triangular Shapes)

The prism portions 53 and/or the prism portions 63 of the first prism sheet 5 and the second prism sheet 6 may have shapes other than triangular poles. For example, the prism portions 53 and/or 63 may be shaped as polygonal poles having slopes inclined relative to the corresponding one of the incident surfaces 51, 61. This design provides the same operations and advantages as described above. This modification also provides a backlight that has an increased brightness in a direction other than the front direction or a backlight that has a higher brightness in two or more specific directions than other directions.

That is, the backlights according to the second embodiment or the modifications of the second embodiment are capable of extract a sufficient amount of light from the organic EL device by the same mechanism as the backlights of the first embodiment shown in Figs. 1 to 15.

The shapes of the prism portions 53 of the first prism sheet 5 may be different form the shapes of the prism portions 63 of the second prism sheet 6.

### (Modification 19: Change Relative Positions of Light Extracting Sheet 1 and First Prism Sheet 5)

The second incident surface 51 of the first prism sheet 5 does not need to be parallel to the first incident surface 11 of the light extracting sheet 1. If the orientation of the longitudinal axes 54 of the first prism portions 53 of the first prism sheet 5 is set appropriate in relation to the shapes and sizes of the pyramids o the light extracting sheet 1, it is possible to provide a backlight that has an increased brightness in a direction other than the front direction or a backlight that has a higher brightness in two or more specific directions than other directions.

Hereinafter, taking the backlight shown in Fig. 16 as an example, the measurement results are shown when the angle θ10 defined by the normal 10N to the first incident surface 11 and the slopes 13b of the first projections 13 on the light extracting sheet 1 shown in Fig. 2 was varied. The conditions of the simulations are shown below.

### (a) Simulation Method

### Ray tracking simulations by Monte Carlo method

### (b) Model of the light extracting property (light emitting direction) of the organic EL device 3

The simulations were performed with the following three light sources. Either that the light emitting property of a typical organic EL device is similar to those of the three light sources below, or that the amount of light of a typical organic EL device in each emitting direction (a relative angle θ when the angle of the normal 10N is set as 0°) is between the maximum amount and the minimum amount of the three light sources in each angle θ.
(First Light Source) The organic EL device 3 having a light emitting property that, when the angle of the normal 10N is set as 0°, the brightness distribution on the transparent substrate 32 is expressed by cos 4θ.
(Second Light Source) The organic EL device 3 having a light emitting property that, when the angle of the normal 10N is set as 0°, the brightness distribution on the transparent substrate 32 is expressed by cosθ.
(Third Light Source) The organic EL device 3 having a light emitting property that, when the angle of the normal 10N is set as 0°, the brightness distribution on the transparent substrate 32 is expressed by (1-90/θ) · sin2θ.

### (c) Structure of Light Extracting Sheet 1

Index of refraction = 1.50
Length of each side of the bottom of each projection 13 (square) = 3 cm
Shape of projections 13 = Square Pyramids
Angle defined by the slopes 13b of the projections 13 and the normal 10N was varied. Table 1 shows the simulated values. In the following, the definition of an angle defined by a line and a surface is the same as explained above.

The projections 13 are densely arranged on an imaginary plane that is parallel to the light first incident surface 11.

### (d) The structure of the first prism sheet 5

Index of refraction of a unit prism = 1.60
Length of each side of the bottom of each second incident surface 51 (square) = 3 cm

The second incident surface 51 is parallel to the first incident surface 11.

The shape of the first prism portions 53 is an isosceles right triangle in which an angle that does not contact an imaginary plane parallel to the second incident surface 51 is the right angle. That is, each plane of the first prism portions 53 is inclined by 45° relative to the normal 11N.

The first prism portions 53 are densely arranged on an imaginary plane perpendicular to the second incident surface 51.

### (e) The structure of the second prism sheet 6

Index of refraction of a unit prism = 1.60
Length of each side of the bottom of each third incident surface 61 (square) = 3 cm

The incident surface 56 is parallel to the first incident surface 11.

The shape of the second prism portions 63 is an isosceles right triangle in which an angle that does not contact an imaginary plane parallel to the third incident surface 61 is the right angle. That is, each plane of the second prism portions 63 is inclined by 45° relative to the normal 11N.

The second prism portions 63 are densely arranged on an imaginary plane perpendicular to the third incident surface 61.

The front brightness is expressed as a brightness ratio to the brightness in a direction of the normal 10N when the first and second prism sheets 5, 6 are provided. Table 1 shows the results of the simulations. The shortest distance between the second incident surface 51 and the light extracting sheet 1 and the shortest distance between the second incident surface 51 and the first prism sheet 5 were changed at random in a range between 5 µm and 10 µm in several simulations. Table 1 shows average values of the front brightness.

**Table 1:**

| Inclination Angle θ and Front Brightness Ratio of Slope of Projection 13 | | | |
|---|---|---|---|
| θ10(deg) | First Light Source | Second Light Source | Third Light Source |
| 15.0 | 1.31 | 2.44 | 4.46 |
| 17.5 | 1.26 | 2.50 | 4.75 |
| 20.0 | 1.13 | 2.51 | 4.92 |
| 22.5 | 1.12 | 2.60 | 5.19 |
| 25.0 | 1.02 | 2.60 | 5.36 |
| 27.5 | 0.92 | 2.51 | 5.13 |
| 30.0 | 0.81 | 2.27 | 4.81 |
| 32.5 | 0.73 | 2.21 | 4.83 |
| 35.0 | 0.79 | 2.44 | 5.09 |
| 37.5 | 0.74 | 2.36 | 5.11 |
| 40.0 | 0.75 | 2.41 | 5.16 |
| 42.5 | 0.74 | 2.53 | 5.39 |
| 45.0 | 0.70 | 2.34 | 5.23 |
| 47.5 | 0.87 | 2.51 | 5.29 |
| 50.0 | 0.91 | 2.54 | 5.30 |
| 52.5 | 1.04 | 2.60 | 5.36 |
| 55.0 | 1.07 | 2.60 | 5.20 |
| 57.5 | 1.10 | 2.58 | 5.25 |
| 60.0 | 1.13 | 2.59 | 5.21 |
| 62.5 | 1.18 | 2.68 | 5.43 |
| 65.0 | 1.20 | 2.73 | 5.32 |
| 67.5 | 1.10 | 2.47 | 5.06 |
| 70.0 | 1.16 | 2.68 | 5.23 |
| 72.5 | 1.21 | 2.50 | 4.96 |
| 75.0 | 1.14 | 2.26 | 4.33 |
| 77.5 | 1.11 | 2.28 | 4.51 |
| 80.0 | 1.04 | 2.00 | 3.72 |
| 82.5 | 0.98 | 1.63 | 2.97 |
| 85.0 | 0.95 | 1.51 | 2.69 |

Table 1 reveals the following.

### (Evaluation A)

Compared to the other light sources, the first light source exerted a significantly higher front brightness ratio without using the light extracting sheet 1. Even when the first light source was used, the front brightness ratio exceeded one in a range of the angle θ10 no less than 15° and less than 27.5° and in a range of the angle θ10 greater than 50.0° and less than 82.5°. As a matter of course, when the other light sources were used, the front brightness exceeded one.

### (Evaluation B)

From the results of the simulation where the light sources 2 and 3 were used, it was found out that when θ10 is in the vicinity of 25.0°, that is, in a range no less than 22.5° and less than 27.5°, the front brightness is maximized.

It was found out from the results of the simulations using the light sources 1 to 3, the front brightness was 90% of the front brightness of the case where θ10 was 25.0° in an angle range no less than 15.0° and less than 30.0°.

### (Evaluation C)

From the results of the simulation where the light sources 2 and 3 were used, it was found out that when θ10 is in the vicinity of 42.5°, that is, in a range greater than 40.0° and less than 45.0°, the front brightness is maximized.

It was found out from the results of the simulations using the light sources 2 to 3, the front brightness was 90% of the front brightness of the case where θ10 was 25.0° in an angle range no less than 32.5° and less than 75.0°.

### (Evaluation D)

From the results of the simulation where the light sources 1 and 3 were used, it was found out that when θ10 is in range between 62.5° and 65.0°, that is, in a range greater than 60.0° and less than 67.5°, the front brightness is maximized.

When the first and second light sources 1, 2 are used, the front brightness was no less than 90% of the front brightness of the case where θ10 was 65.0° in an angle range greater than 32.5° and less than 80°. When the third light source is used, the front brightness was no less than 90% of the front brightness of the case where θ10 was 62.5° in an angle range greater than 32.5° and less than 80°. In an angle range greater than 55.0° and less than 75.0°, the front brightness was no less than 90% of the maximum front brightness in all the three light sources 1 to 3.

### (Evaluation E)

From the results of the simulation where the light sources 1 and 3 were used, it was found out that when θ10 is in range between 70.0° and 72.5°, that is, in a range greater than 67.5° and less than 75°, the front brightness is maximized.

When the first sources 1 was used, the front brightness was no less than 90% of the front brightness of the case where θ10 was 72.5° in an angle range greater than 15.0° and less than 80.0°. When the second and third light sources were used, the front brightness was no less than 90% of the front brightness of the case where θ10 was 70.0° in an angle range greater than 15.0° and less than 80.0°. In an angle range greater than 55.0° and less than 75.0°, the front brightness was no less than 90% of the maximum front brightness in all the three light sources 1 to 3.

Although all the slopes are preferably in any of the above listed angle ranges, the results will be favorable for the above explained reasons as long as at least one of the slopes is in any of the listed ranges. Also, if designed to have slopes in any of these angle ranges, the light extracting sheet 1 and the prism sheet 2 according to the first embodiment provide higher front brightness.

A light extracting sheet is provided on a light extracting surface of an organic EL device. A prism sheet is provided on the light extracting sheet. The light extracting sheet has a first incident surface contacting the light extracting surface and a light exit surface located at an opposite side from the first incident surface. The light exit surface defines a plurality of first projections. Each of the first projections is pyramid. The prism sheet has a second incident surface that is substantially parallel to the light extracting surface and a light exit surface located at an opposite side from the second incident surface. The light exit surface defines a plurality of second projections. Each of the second projections is pyramid.

## Claims

1. A light-emitting apparatus, comprising:
an area light-emitting device having a light extracting surface, wherein the area light-emitting device has an isotropic light emission property;
a transparent light extracting member provided on the light extracting surface, wherein the light extracting member has a first incident surface contacting the light extracting surface and a light exit surface located at an opposite side from the first incident surface, wherein the light exit surface defines a plurality of first projections and/or first recesses, the first projections projecting away from the first incident surface, and the first recesses being dented toward the first incident surface, wherein each of the first projections and the first recesses is shaped as n-gonal pyramid or truncated n-gonal pyramid, the pyramid and truncated pyramid having a bottom that is an imaginary plane substantially parallel to the first incident surface; and
a transparent optical device provided on the light extracting member, the optical device changing an optical path of light that reaches the device, wherein the optical device has a second incident surface that is substantially parallel to the light extracting surface and a light exit surface located at an opposite side from the second incident surface,
wherein the light exit surface defines a plurality of second projections and/or second recesses, the second projections projecting away from the second incident surface, and the second recesses being dented toward the second incident surface, wherein each of the second projections and the second recesses is shaped as m-gonal pyramid or truncated m-gonal pyramid, the pyramid and the truncated pyramid having a bottom that is an imaginary plane substantially parallel to the second incident surface, the apparatus being **characterized in that**:
n and m are each a natural number that is greater than three, and the numbers n and m satisfy one of the following requirements (i) and (ii):
(i) the number n is obtained by multiplying the number m by a natural number; and
(ii) the number m is obtained by multiplying the number n by a natural number.

2. A light emitting apparatus, comprising:
an area light-emitting device having a light extracting surface, wherein the area light-emitting device has an isotropic light emission property;
a transparent light extracting member provided on the light extracting surface, wherein the light extracting member has a first incident surface contacting the light extracting surface and a light exit surface located at an opposite side from the first incident surface, wherein the light exit surface defines a plurality of first projections and/or first recesses, the first projections projecting away from the first incident surface, and the first recesses being dented toward the first incident surface, wherein each of the first projections and the first recesses is shaped as n-gonal pyramid or truncated n-gonal pyramid, the pyramid and truncated pyramid having a bottom that is an imaginary plane substantially parallel to the first incident surface; and
a transparent optical device provided on the light extracting member, the optical device changing an optical path of light that reaches the device, wherein the optical device has a light exit surface that is substantially parallel to the light extracting surface and a second incident surface located at an opposite side from the light exit surface, wherein the second incident surface defines a plurality of second projections and/or second recesses, the second projections projecting away from the light exit surface, and the second recesses being dented toward the light exit surface, wherein each of the second projections and the second recesses is shaped as m-gonal pyramid or truncated m-gonal pyramid, the pyramid and the truncated pyramid having a bottom that is an imaginary plane substantially parallel to the light exit surface, the apparatus being **characterized in that**:
n and m are each a natural number that is greater than three, and the numbers n and m satisfy one of the following requirements (i) and (ii):
(i) the number n is obtained by multiplying the number m by a natural number; and
(ii) the number m is obtained by multiplying the number n by a natural number.

3. The light-emitting apparatus according to claim 1 or 2, **characterized in that** the light extracting member also functions as a substrate of the area light-emitting device.

4. The light-emitting apparatus according to claim 1 or 2, **characterized in that** the apparatus satisfies at least one of the following requirements (iii) to (v):
(iii) the n-gonal pyramids are equilateral n-gonal pyramids, and the truncated n-gonal pyramids are equilateral truncated n-gonal pyramids;
(iv) the second projections and the second recesses are shaped as equilateral n-gonal pyramids or equilateral truncated n-gonal pyramids; and
(v) the m-gonal pyramids are equilateral m-gonal pyramids, and the truncated m-gonal pyramids are equilateral truncated m-gonal pyramids.

5. The light-emitting apparatus according to claim 1 or 2, **characterized in that** the apparatus satisfies at least one of the following requirements (vi) and (vii):
(vi) the first projections and/or the first recesses are arranged such that each of the sides defining the bottoms the n-gonal pyramids or each of the sides defining the truncated n-gonal pyramids is common to one of the sides of an adjacent n-gonal pyramid or an adjacent truncated n-gonal pyramid, and
(vii) the second projections and/or the second recesses are arranged such that each of the sides defining the bottoms the m-gonal pyramids or each of the sides defining the truncated m-gonal pyramids is common to one of the sides of an adjacent m-gonal pyramid or an adjacent truncated m-gonal pyramid.

6. The light-emitting apparatus according to claim 1 or 2, **characterized in that** the number n or the number m is three, four, or six.

7. The light-emitting apparatus according to claim 1 or 2, **characterized in that** the area light-emitting device is an organic electroluminescent device or an inorganic electroluminescent device.

8. The light-emitting apparatus according to claim 1 or 2, **characterized in that** parts of the light exit surface that define the first projections and/or the first recesses include a plurality of sides of the n-gonal pyramids or the truncated n-gonal pyramids, each of the sides being a slope, and wherein, with respect to the normal to a plane that is substantially parallel to the first incident surface, the angle of at least one of the slopes is in a range no less than 15° and less than 27.5° or in a range greater than 50° and less than 82.5°.

9. The light-emitting apparatus according to claim 1 or 2, **characterized in that**, with respect to the normal to a plane that is substantially parallel to the incident surface, the angles of all the slopes are in a range no less than 15° and less than 27.5° or in a range greater than 50.0° and less than 82.5°.

10. A light emitting apparatus, **characterized by**:
an area light-emitting device having a light extracting surface, wherein the area light-emitting device has an isotropic light emission property;
a transparent light extracting member provided on the light extracting surface, wherein the light extracting member has a first incident surface contacting the light extracting surface and a light exit surface located at an opposite side from the first incident surface, wherein the light exit surface defines a plurality of first projections and/or first recesses, the first projections projecting away from the first incident surface, and the first recesses being dented toward the first incident surface, wherein each of the first projections and the first recesses is shaped as square pyramid or truncated square pyramid, the pyramid and truncated pyramid having a bottom that is an imaginary plane substantially parallel to the first incident surface; and
a first optical device and a second optical device provided on the light extracting member, each optical device changing an optical path of light that reaches the device,
wherein each of the first and second optical devices has a second incident surface that is substantially parallel to the light extracting surface, and wherein a plurality of pole shaped unit prisms are arranged at an opposite side from the second incident surface such that the longitudinal axes of the unit prisms are substantially parallel to one another,
wherein the first optical device is arranged such that its incident surface faces the light exit surface of the light extracting member,
wherein the second optical device is arranged such that its incident surface faces the second incident surface of the first optical device or the unit prisms of the first optical device, and
wherein the longitudinal axes of the unit prisms provided on the second optical device are substantially perpendicular to the longitudinal axes of the unit prisms provided on the first optical device.

11. The light-emitting apparatus according to claim 10, **characterized in that** the light extracting member also functions as a substrate of the area light-emitting device.

12. The light-emitting apparatus according to claim 10, **characterized in that** the area light-emitting device is an organic electroluminescent device or an inorganic electroluminescent device.

13. The light-emitting apparatus according to any one of claims 10 to 12, **characterized in that** parts of the light exit surface that define the first projections and/or the first recesses include a plurality of sides of the n-gonal pyramids or the truncated n-gonal pyramids, each of the sides being a slope, and wherein, with respect to the normal to a plane that is substantially parallel to the first incident surface, the angle of at least one of the slopes is in a range no less than 15° and less than 27.5° or in a range greater than 50° and less than 82.5°.

14. The light-emitting apparatus according to claim 13, **characterized in that**, with respect to the normal to a plane that is substantially parallel to the incident surface of the light extracting member, the angles of all the slopes are in a range no less than 15° and less than 27.5° or in a range greater than 50.0° and less than 82.5°.
